**Europäisches Patentamt**

**European Patent Office**

**Office européen des brevets**

(19)

(11) Veröffentlichungsnummer : **0 142 632 B1**

(12) **EUROPÄISCHE PATENTSCHRIFT**

(45) Veröffentlichungstag der Patentschrift : 04.05.88

(51) Int. Cl.⁴ : **H 01 L 21/00, H 01 L 21/285**

(21) Anmeldenummer : **84109902.1**

(22) Anmeldetag : **20.08.84**

(54) **Verfahren zum Herstellen von Bipolartransistorstrukturen mit selbstjustierten Emitter- und Basisbereichen für Höchstfrequenzschaltungen.**

(30) Priorität : 26.08.83 DE 3330895

(43) Veröffentlichungstag der Anmeldung : 29.05.85 Patentblatt 85/22

(45) Bekanntmachung des Hinweises auf die Patenterteilung : 04.05.88 Patentblatt 88/18

(84) Benannte Vertragsstaaten : **AT BE DE FR GB IT NL SE**

(56) Entgegenhaltungen : EP-A- 0 071 494 IBM TECHNICAL DISCLOSURE BULLETIN, Band 25, Nr. 8, Januar 1983, Seiten 4433-4435, New York, US; I. ANTIPOV et al.: "Polysilicon-base transistor structure with improved characteristics"

(73) Patentinhaber : **Siemens Aktiengesellschaft Berlin und München Wittelsbacherplatz 2 D-8000 München 2 (DE)**

(72) Erfinder : **Wieder, Armin, Dr. Ing. Wiesmahdstrasse 9 D-8035 Gauting (DE)** Erfinder : **Schaber, Hans-Christian, Dr. rer. nat. Kreuzlingerstrasse 72 D-8034 Germering (DE)** Erfinder : **Schwarzl, Siegfried, Dr. rer. nat. Putzbrunner Strasse 159 D-8012 Ottobrunn (DE)**

**Beschreibung**

Die vorliegende Patentanmeldung betrifft ein Verfahren zum Herstellen von Bipolartransistorstrukturen mit selbstjustierten Emitter-Basisbereichen für Höchstfrequenzschaltungen.

In der nachveröffentlichten Patentanmeldung gemäß DE-A-3 243 059 ist ein Verfahren zum Herstellen von Bipolartransistoren mit selbstjustierten Emitter- und Basisbereichen vorgeschlagen worden, bei dem sowohl der Emitterbereich als auch der Basisbereich im Halbleitersubstrat durch Ausdiffusion der aus dotierten Polysiliziumschichten bestehenden, direkt auf dem Substrat abgeschiedenen Strukturen erzeugt werden, wobei mittels Siliziumoxid-Schichten als Maskierungs- und Isolationsschichten der Emitterbereich zentral im Basisbereich so erzeugt wird, daß unter dem Emitterbereich die aktive Basiszone und symmetrisch dazu eine inaktive Basiszone entsteht und bei dem zur Strukturierung der Siliziumoxid- und Polysiliziumschichten vertikale Ätzprofile erzeugende Trockenätzverfahren verwendet werden.

In herkömmlichen Bipolar-Strukturen werden Basis- und Emitterbereich durch Ionenimplantation von Dotierstoffen und Ausdiffusion der dotierten Ionen in das Siliziumsubstrat erzeugt, wobei mit entsprechenden Justiertoleranzen der Emitter überlappungsfrei in den Basisbereich justiert werden muß. Dieses Erfordernis bedingt relativ große Strukturen, die auch noch durch das grobe Metallraster bestimmt sind, da aus der Metall-Leiterbahnebene Kontakte sowohl zur Emitter- und Kollektorzone als auch zur Basiszone hergestellt werden müssen.

Die selbstjustierte Herstellung von Emitter und Basis, wie sie in dem eingangs beschriebenen Verfahren bereits vorgeschlagen worden ist, schließt diese Nachteile prinzipiell aus. Die Realisierung der Strukturen mit Hilfe von dotierten Polysilizium ermöglicht die Ausnutzung von verschiedenen weiteren Vorteilen, wie wesentlich kleineren Basiswiderständen, kleineren Kapazitäten und der Möglichkeit einer lokalen Verdrahtung in den Polysiliziumebenen.

Ein Verfahren, in dem auch selbstjustierte Emitter-Basis-Bipolarstrukturen für hohe Anforderungen bei niedrigen Leistungen und kleinen Gatterlaufzeiten hergestellt werden, ist aus einem Aufsatz von Ning et al aus dem IEEE Transactions on Electron Devices, Vol. ED-28, No. 9, September 1981, auf den Seiten 1010 bis 1013 zu entnehmen. Bei diesem Verfahren wird die Trennung des Emitter-Basiskontaktes nur durch die Dicke des Flankenoxids, welches im Bereich des Siliziumsubstrates 0,4 μm beträgt, bestimmt. Das Flankenoxid wird abgeschieden nach der Strukturierung der den Basisanschluß bildenden bordotierten Polysiliziumschicht zur Freilegung des Emitterbereiches, die teilweise durch vertikale Ätzprofile erzeugende Trockenätzung und für den Rest der Schichtdicke mittels einer dotierungsselektiven naßchemischen Ätzung in einem Flußsäure-Salpetersäure-Essigsäure-Ätzgemisch erfolgt.

Die durch die bekannten Verfahren erhaltenen selbstjustierten Emitter-Basis-Strukturen weisen den Mangel auf, daß sie nicht mit genügender Reproduzierbarkeit hergestellt werden können, da die bei dem naßchemischen Ätzschritt unvermeidbare laterale Unterätzung schwer kontrollierbar ist.

Aus dem IBM Technical Disclosure Bulletin, Bd. 25, Nr. 8, Januar 1983, Seiten 4433-4435 ist auch ein Verfahren zum Herstellen von Bipolartransistorstrukturen mit selbstjustierten Emitter-Basis bekannt, das Trockenätzung Verwendet. Bei diesem Verfahren wird ebenfalls eine Verbreiterung der Flankenisolation bewirkt.

Aufgabe der Erfindung ist es, ein Verfahren anzugeben, durch das selbstjustierte Polysilizium-Emitter-Basisstrukturen für Bipolartransistoren reproduzierbar und in einfachen Verfahrensschritten herstellbar sind.

Diese Aufgabe wird durch den Ablauf der folgenden Verfahrensschritte gelöst :

a) Aufbringen einer ersten Siliziumoxidschicht auf einem Siliziumhalbleitersubstrat und Strukturierung dieser ersten Oxidschicht so, daß der als Basis bestimmte Bereich an der Substratoberfläche freigelegt wird,

b) ganzflächige Abscheidung einer ersten dotierten Polysiliziumschicht in einer Schichtdicke im Bereich von etwa 300 nm und Implantation der ersten Polysiliziumschicht mit Borionen bis zu einer Tiefe, die maximal der halben Schichtdicke entspricht,

c) Abscheidung einer ganzflächigen zweiten Siliziumoxidschicht,

d) Durchführung einer Fotolacktechnik zur Definition des Basisbereiches und des im Basisbereich liegenden Emitterbereiches,

e) Durchführung eines anisotropen reaktiven Ionenätzverfahrens zur Entfernung der nicht mit der Fotolackmaske bedeckten zweiten Siliziumoxidschicht,

f) Durchführung eines anisotropen reaktiven Ionenätzverfahrens zur Entfernung der nicht mit der zweiten Siliziumoxidschicht bedeckten ersten Polysiliziumschicht in dem Maße, daß maximal etwa 100 nm der ersten Polysiliziumschicht auf der Substratoberfläche verbleibt,

g) Erzeugung einer dritten Siliziumoxidschicht zur Herstellung der Flankenisolation durch Aufoxidation der restlichen Poly-Si Schicht,

h) Abscheidung einer vierten Siliziumoxidschicht zur Verbreiterung der Flankenisolation,

i) Durchführung eines anisotropen reaktiven Ionenätzverfahrens ohne Maske zur Entfernung der vierten Siliziumoxidschicht mit Ausnahme der Flankenisolation und zur Entfernung der dritten Siliziumoxidschicht im Emitterbereich, wobei die Vertikalätzrate : Lateralätzrate > 5 :1 und die Oxidätzrate : Siliziumätzrate > 15 :1 beträgt,

j) Abscheidung und Strukturierung einer zweiten, mit Arsen oder Antimon dotierten Polysiliziumschicht im Emitterbereich,

k) Durchführung einer thermischen Behandlung zur Aktivierung des Emitterbereiches und der Basisbereiche und

l) Öffnen der Kontakte zu den Polysiliziumbereichen und der Basis- und Emitteranschlüsse.

Ausgestaltungen der Erfindung sind in Unteransprüchen gekennzeichnet.

Durch das Verfahren nach der Lehre der Erfindung ist die Möglichkeit gegeben, bedingt durch die Verbreiterung der lateralen Flankenisolation (spacer) durch die gut kantenbedeckende Oxidschicht, Bipolartransistorstrukturen für höchste Anforderungen in Bezug auf kleine Basis-Kollektorkapazitäten und kleine Basiswiderstände, das heißt letztlich hohe Schaltgeschwindigkeiten reproduzierbar herzustellen.

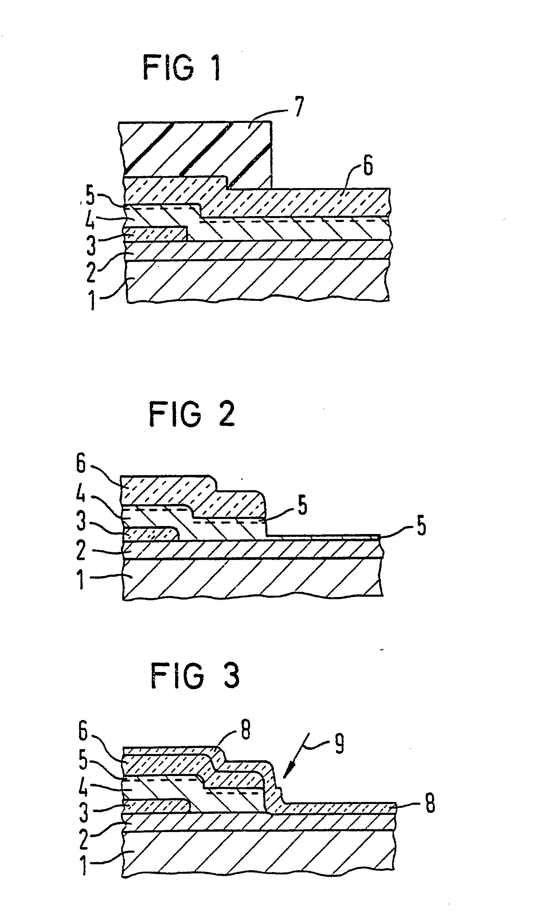

Im folgenden wird die Erfindung anhand der Figuren 1 bis 6, die im Schnittbild aufeinanderfolgende erfindungswesentliche Herstellungsschritte bis zu einer erfindungsgemäßen Emitter-Basis-Struktur darstellen, noch näher erläutert. Dabei ist der besseren Übersicht wegen in den Figuren 1 bis 5 nur die spiegelbildlich symmetrische Hälfte des Emitter-Basis-Kontaktbereiches der Anordnung dargestellt. Für gleiche Teile gelten in allen Figuren gleiche Bezugszeichen.

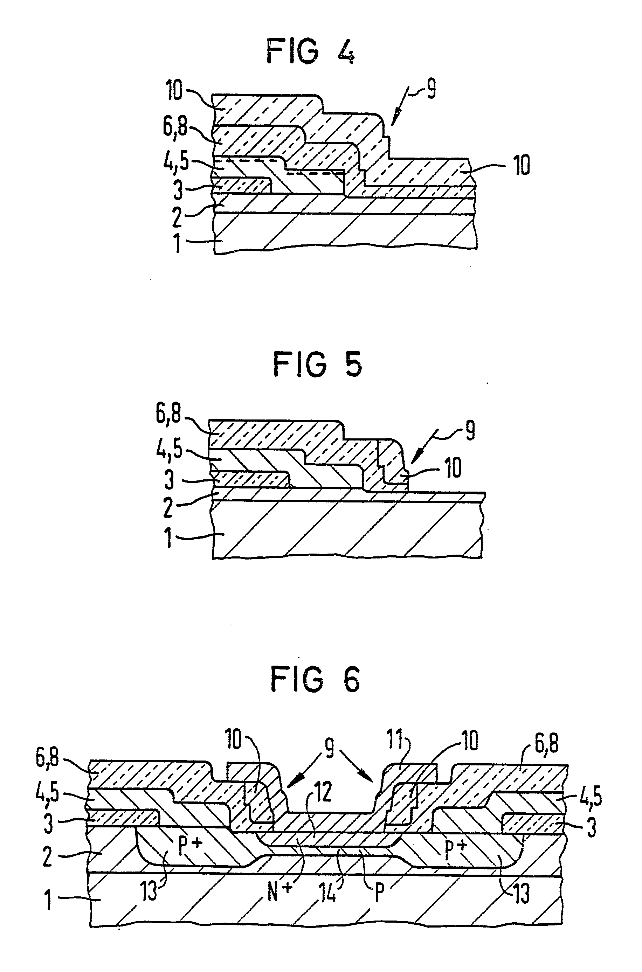

Figur 1 : Auf ein, mit einer $n^-$-dotierten Epitaxieschicht 2 versehenes $n^+$-dotiertes Siliziumsubstrat 1 wird eine erste Siliziumoxidschicht 3 in einer Schichtdicke im Bereich von 200 bis 400 nm aufgebracht und so strukturiert, daß ein der späteren Basiszone entsprechender Bereich auf der Substratoberfläche 1, 2 freigelegt wird. Dann erfolgt eine erste ganzflächige Abscheidung (300 nm) von undotiertem Polysilizium 4 aus der Gasphase durch thermische Zersetzung von Silan, die anschließend in ihrer obersten Schicht 5 mit Bor-Ionen implantiert wird, wobei eine hohe Dosis von ca. $5 \times 10^{15}$ cm$^{-2}$ und eine niedrige Energie von ca. 40 keV eingestellt wird. Auf die Polysiziumschicht 4, 5 wird durch ein CVD-Verfahren (= chemical vapor deposition) ganzflächig eine zweite SiO$_2$-Schicht 6 in einer Schichtdicke von 400 nm aufgebracht. Mit einer Fotolackmaske 7 werden dann die selbstjustierten Emitter-Basis-Bereiche (in Figur 6 die Bereiche 12 und 14) definiert. Es entsteht die in Figur 1 dargestellte Struktur.

Figur 2 : Mit Hilfe eines reaktiven Ionenätzverfahrens zunächst mittels einer Gasmischung aus Trifluormethan und 5 bis 8 % Sauerstoff wird nun unter Verwendung der Fotolackmaske 7 das freiliegende Oxid 6 entfernt und anschließend mittels eines Gemisches aus Bortrichlorid, Chlor und Helium das Polysilizium 4, 5 bis auf eine Restschicht von ca. 50 nm abgeätzt, wobei der genaue Ätzstopp unkritisch und damit durch den Farbumschlag auf dem nahezu vollständig mit Oxid (3) bedeckten Siliziumsubstrat (1, 2) bestimmbar ist. Es ergibt sich die Anordnung nach Figur 2.

Die nächsten Verfahrensschritte dienen der Oxidflankenisolation (9).

Figur 3 : Die Herstellung der dritten Oxidschicht 8 von ca. 150 nm Dicke erfolgt durch Aufoxidation bei Normaldruck oder zur Verhinderung der Bildung von Sauerstoff induzierten Stapelfehlern und zur Verringerung der lateralen Ausdiffusion von Bor (5) in die Polysiliziumschicht 4 vorzugsweise auch im Hochdruckbereich. Die Oxidation erfolgt zum Beispiel bei Normaldruck bei 800 °C für 5 Stunden oder bei 20 bar, 800 °C für ca. 20 Minuten. Wie durch den Pfeil 9 dargestellt ist, wird durch die Aufoxidation an den Polysiziumflanken 4, 5 bereits eine Kantenbedeckung erreicht.

Figur 4 : Auf die durch Oxidation erzeugte dritte Oxidschicht 8 wird zur Verbreiterung der lateralen Flankenisolation (spacer, siehe Pfeil 9) eine weitere vierte Oxidschicht 10 aus der Gasphase (CVD-Verfahren) in einer Schichtdicke von 250 nm abgeschieden.

Figur 5 : Durch ein anisotropes Ätzverfahren, zum Beispiel durch reaktives Ionenätzen (RIE) in einem Trifluormethan-Sauerstoff-Gemisch wird nun ohne Maskierung, das heißt ganzflächig, zunächst die vierte Siliziumoxidschicht 10 mit Ausnahme der Flankenisolation (siehe Pfeil 9) und anschließend die dritte Siliziumoxidschicht 8 im Emitterbereich (12) in einer Schichtdicke von 400 nm mit genügender Selektivität zum einkristallinen Siliziumsubstrat 1, 2 entfernt, wobei die Vertikalätzrate : Lateralätzrate > 5 :1 und die Oxidätzrate : Siliziumätzrate > 15 :1 beträgt. Durch diesen Ätzprozeß wird der Basisbereich durch die laterale Flankenisolation 9 selbstjustierend gegen den Emitterbereich isoliert.

Figur 6 : Im freiliegenden Emitterbereich (12) wird eine sorgfältige Oberflächenbehandlung des Siliziumsubstrates 1, 2 zur Vermeidung von Verunreinigungen und Rauhigkeiten vor der Polysiziumabscheidung für den Polysiliziumemitter durchgeführt, wobei sich möglicherweise die Bildung einer dünnen (< 3 nm) geschlossenen Oxidschicht an der Grenzfläche als vorteilhaft für die elektrischen Parameter erweist. Diese Oxidschicht kann jedoch auch entfallen. Dann wird eine aus $n^+$-dotiertem Polysilizium (Arsen) bestehende zweite Polysiliziumschicht 11 abgeschieden und so strukturiert, daß sie überlappend auf der ersten Polysiliziumschicht 4, 5 den Emitterbereich 12 überdeckt. Die Struktur wird in einem einzigen Hochtemperaturschritt bei 950 bis 1 000 °C während einer Zeitdauer von ca. 30 Minuten aktiviert, wobei durch die Bordotierung der ersten Polysiliziumschicht 4, 5 sowohl in dem einkristallinen Siliziumsubstrat 1, 2 die aktive Basiszone 14, die inaktive Basiszone 13 als auch aus der Polysiliziumschicht 11 die sehr flache Emitterzone 12 gebildet wird. Die Fertigstellung der Bauelementestruktur erfolgt in bekannter Weise durch Aufbringen einer fünften Siliziumoxidschicht als Isolationsoxid, Einbringen von Kontaktlöchern zu den Polysiliziumbereichen und dem Kollektorbereich und Durchführung der Metallisierung für die Transistoranschlüsse.

**Patentansprüche**

1. Verfahren zum Herstellen von Bipolartransistorstrukturen mit selbstjustierten Emitter-Basis-bereichen für Höchstfrequenzschaltungen, bei dem sowohl der Emitterbereich (12) als auch der Basisbereich (13, 14) im Halbleitersubstrat (1, 2) durch Ausdiffusion der aus dotierten Polysiliziumschichten (4, 5, 11) bestehenden, direkt auf dem Substrat (1, 2) abgeschiedenen Strukturen erzeugt werden, wobei mittels Siliziumoxid-Schichten (3, 6, 8, 10) als Maskierungs- und Isolationsschichten der Emitterbereich (12) zentral im Basisbereich (13, 14) so erzeugt wird, daß unter dem Emitterbereich (12) die aktive Basiszone (14) und symmetrisch dazu eine inaktive Basiszone (13) entsteht und bei dem zur Strukturierung der Siliziumoxid- (3, 6, 8, 10) und Polysiliziumschichten (4, 11) vertikale Ätzprofile erzeugende Trockenätzverfahren verwendet werden, mit dem Ablauf der folgenden Verfahrensschritte :

a) Aufbringen einer ersten Siliziumoxidschicht (3) auf einem Siliziumhalbleitersubstrat (1, 2) und Strukturierung dieser ersten Oxidschicht (3) so, daß der als Basis bestimmte Bereich (13, 14) an der Substratoberfläche (1, 2) freigelegt wird,

b) ganzflächige Abscheidung einer ersten undotierten Polysiliziumschicht (4) in einer Schichtdicke im Bereich von etwa 300 nm und Implantation der ersten Polysiliziumschicht (4) mit Borionen (5) bis zu einer Tiefe, die maximal der halben Schichtdicke (4) entspricht,

c) Abscheidung einer ganzflächigen zweiten Siliziumoxidschicht (6),

d) Durchführung einer Fotolacktechnik (7) zur Definition des Basisbereiches (13, 14) und des im Basisbereich (13, 14) liegenden Emitterbereiches (12),

e) Durchführung eines anisotropen reaktiven Ionenätzverfahrens zur Entfernung der nicht mit der Fotolackmaske (7) bedeckten zweiten Siliziumoxidschicht (6),

f) Durchführung eines anisotropen reaktiven Ionenätzverfahrens zur Entfernung der nicht mit der zweiten Siliziumoxidschicht (6) bedeckten ersten Polysiliziumschicht (4, 5) in dem Maße, daß maximal etwa 100 nm der ersten Polysiliziumschicht (4) auf der Substratoberfläche (1, 2) verbleibt,

g) Erzeugung einer dritten Siliziumoxidschicht (8) zur Herstellung der Flankenisolation (siehe Pfeil 9) durch Aufoxidation der restlichen Polysiliziumschicht,

h) Abscheidung einer vierten Siliziumoxidschicht (10) zur Verbreiterung der Flankenisolation (9),

i) Durchführung eines anisotropen reaktiven Ionenätzverfahrens ohne Maske zur Entfernung der vierten Siliziumoxidschicht (10) mit Ausnahme der Flankenisolation (9) und zur Entfernung der dritten Siliziumoxidschicht (8) im Emitterbereich (12), wobei die Vertikalätzrate : Lateralätzrate > 5 :1 und die Oxidätzrate : Siliziumätzrate > 15 : 1 beträgt,

j) Abscheidung und Strukturierung einer zweiten, mit Arsen oder Antimon dotierten Polysiliziumschicht (11) im Emitterbereich (12),

k) Durchführung einer thermischen Behandlung zur Aktivierung des Emitterbereiches (12) und der Basisbereiche (13, 14) und

l) Öffnen der Kontakte zu den Polysiliziumbereichen (4, 5, 11) und der Basis- (13) und Emitteranschlüsse (11).

2. Verfahren nach Anspruch 1, dadurch gekennzeichnet, daß ein, mit einer $n^-$-dotierten Epitaxieschicht (2) versehenes n-dotiertes Siliziumsubstrat (1) verwendet wird.

3. Verfahren nach Anspruch 1 und/oder 2, dadurch gekennzeichnet, daß anstelle des Verfahrensschrittes a) die Grabenisolationstechnik oder lokale Oxidation (LOCOS-Technik) angewandt wird.

4. Verfahren nach Anspruch 1 bis 3, dadurch gekennzeichnet, daß die Dicke der zweiten Oxidschicht (6) nach Verfahrensschritt c) auf einen Wert im Bereich von 400 nm, die Dicke der dritten Oxidschicht (8) nach Verfahrensschritt g) auf einen Wert im Bereich von 150 nm und die der vierten Oxidschicht (10) nach Verfahrensschritt h) auf einen Wert im Bereich von 250 nm eingestellt wird.

5. Verfahren nach Anspruch 1 bis 4, dadurch gekennzeichnet, daß die Dicke der ersten (4) und zweiten Polysiliziumschicht (11) auf einen Wert im Bereich von 300 nm eingestellt wird.

6. Verfahren nach Anspruch 1 bis 5, dadurch gekennzeichnet, daß bei der Bor-Ionenimplanta-tion (5) nach Verfahrensschritt b) eine Dosis von $5 \times 10^{15}$ cm$^{-2}$ und eine Energie von 40 keV eingestellt wird.

7. Verfahren nach Anspruch 1 bis 6, dadurch gekennzeichnet, daß das reaktive Ionenätzverfah-ren nach Verfahrensschritt e) und i) mit einem Gemisch aus Trifluormethan (CHF$_3$) und 5 bis 8 % Sauerstoff und das reaktive Ionenätzverfahren nach Verfahrensschritt f) mit einem Gemisch aus Bortrichlorid (BCl$_3$), Chlor und Helium durchge-führt wird.

8. Verfahren nach Anspruch 1 bis 7, dadurch gekennzeichnet, daß die thermische Behandlung nach Verfahrensschritt l) 30 Minuten bei 950 bis 1000 °C durchgeführt wird.

9. Verfahren nach Anspruch 1 bis 8, dadurch gekennzeichnet, daß die Erzeugung der Siliziumoxidschicht (8) nach Verfahrensschritt g) bei Normaldruck bei 800°C in 5 Stunden erfolgt.

10. Verfahren nach Anspruch 1 bis 8, dadurch gekennzeichnet, daß die Erzeugung der Siliziumoxidschicht (8) nach Verfahrensschritt g) bei Hochdruck im Bereich von 20 bar bei 800°C in 20 Minuten erfolgt.

## Claims

1. A process for the production of bipolar transistor structures having self-aligned emitter-base zones, for ultra high frequency circuits, wherein both the emitter zone (12) and the base zone (13, 14) are formed in the semiconductor substrate (1, 2) by diffusion out of the structures which are directly deposited on the substrate (1,

2) and which consist of doped polysilicon layers (4, 5, 11), where using silicon oxide layers (3, 6, 8, 10) as masking- and insulating layers, the emitter zone (12) is formed centrally in the base zone (13, 14) in such manner that the active base zone (14) is formed beneath the emitter zone (12) and an inactive base zone (13) is formed symmetrically with the active base zone, and where dry etching steps which form vertical etching profiles are used to structure the silicon oxide layers (3, 6, 8, 10) and polysilicon layers (4, 11), comprising the sequence of the following process steps :

a) application of a first silicon oxide layer (3) to a silicon semiconductor substrate (1, 2) and structuring of this first oxide layer (3) in such manner that the zone (13, 14), which is allotted as the base, is exposed at the substrate surface (1, 2),

b) deposition of a first undoped polysilicon layer (4) in a thickness in the region of about 300 nm on to the entire surface, and implantation of the first polysilicon layer (4) with boron ions (5) to a depth which corresponds at most to half the layer thickness (4),

c) deposition of a second silicon oxide layer (6) on to the entire surface,

d) carrying out of a photo-resist step (7) in order to define the base zone (13, 14) and the emitter zone (12) which is located in the base zone (13, 14),

e) carrying out of an anisotropic, reactive ion etching step to remove the second silicon oxide layer (6) where it is not covered by the photo-resist mask (7),

f) carrying out of an anisotropic, reactive ion etching step to remove the first polysilicon layer (4, 5), where it is not covered by the second silicon oxide layer (6), to the extent that at most about 100 nm of the first polysilicon layer (4) remains on the substrate surface (1, 2),

g) formation of a third silicon oxide layer (8) for the production of the sidewall insulation (see arrow 9) by oxidation of the remaining polysilicon layer,

h) deposition of a fourth silicon oxide layer (10) to widen the sidewall insulation (9),

i) carrying out of an anisotropic, reactive ion etching step without a mask to remove the fourth silicon oxide layer (10), with the exception of the sidewall insulation (9), and in order to remove the third silicon oxide layer (8) in the emitter zone (12), where the ratio of the vertical etching rate to the lateral etching rate is greater than 5 :1, and the ratio of the oxide etching rate to the silicon etching rate is greater than 15 :1,

j) deposition and structuring of a second polysilicon layer (11), doped with arsenic or antimony, in the emitter zone (12),

k) carrying out of a thermal treatment to activate the emitter zone (12) and the base zones (13, 14) and

l) opening of the contacts to the polysilicon zones (4, 5, 11) and the base (13) and emitter terminals (11).

2. A process as claimed in Claim 1, characterised in that an n-doped silicon substrate (1) provided with a n⁻-doped epitaxial layer (2), is used.

3. A process as claimed in Claim 1 and/or 2, characterised in that in place of process step a) a trench insulation step or local oxidation (LOCOS) step is used.

4. A process as claimed in Claim 1 to 3, characterised in that the thickness of the second oxide layer (6) in accordance with process step c) is set at a value in the region of 400 nm, the thickness of the third oxide layer (8) in accordance with process step g) is set at a value in the region of 150 nm, and the thickness of the fourth oxide layer (10) in accordance with process step h) is set at a value in the region of 250 nm.

5. A process as claimed in Claim 1 to 4, characterised in that the thickness of the first polysilicon layer (4) and of the second polysilicon layer (11) is set at a value in the region of 300 nm.

6. A process as claimed in Claim 1 to 5, characterised in that in the boron ion implantation (5) in accordance with process step b), a dose of $5 \times 10^{15}$ cm⁻² and an energy of 40 keV are set.

7. A process as claimed in Claim 1 to 6, characterised in that the reactive ion etching step in accordance with process steps e) and i) is carried out using a mixture of trifluoromethane ($CHF_3$) and 5 to 8 % oxygen, and the reactive ion etching step in accordance with process step f) is carried out using a mixture of boron trichloride ($BCl_3$), chlorine and helium.

8. A process as claimed in Claim 1 to 7, characterised in that the thermal treatment in accordance with process step 1) is carried out for 30 minutes at 950 to 1 000 ºC.

9. A process as claimed in Claim 1 to 8, characterised in that the formation of the silicon oxide layer (8) in accordance with process step g) is carried out at normal pressure at 800 ºC for 5 hours.

10. A process as claimed in Claim 1 to 8, characterised in that the formation of the silicon oxide layer (8) in accordance with process step g) is carried out at high pressure in the region of 20 bar at 800 ºC for 20 minutes.

**Revendications**

1. Procédé pour fabriquer des structures de transistors bipolaires comportant des régions émetteur-base auto-alignées, pour des circuits à très hautes fréquences, et selon lequel on réalise aussi bien la région d'émetteur (12) que la région de base (13, 14) dans le substrat semi-conducteur (1, 2) par diffusion des structures constituées par des couches de polysilicium dopées (4, 5, 11) et déposées directement sur le substrat (1, 2), auquel cas on forme la région d'émetteur (12) dans la partie centrale à l'intérieur de la région de base (13, 14), au moyen de couches d'oxyde de silicium (3, 6, 8, 10) utilisées en tant que couches de masquage et d'isolation, de telle sorte qu'on obtient, au-dessous de la région d'émetteur (12), la zone active de base (14) et, dans une position symétrique par rapport à cette dernière, une zone de base inactive (13), et selon lequel pour réaliser la structuration des couches d'oxyde de silicium (3, 6, 8, 10) et des couches de polysilicium (4, 11), on utilise des procédés de corrosion à sec produisant des profils de corrosion verticaux, avec la mise en oeuvre des étapes opératoires suivantes :

a) dépôt d'une première couche d'oxyde de silicium (3) sur un substrat semi-conducteur en silicium (1, 2) et structuration de cette première couche d'oxyde (3) en sorte que la région (13, 14) destinée à former la base est mise à nu au niveau de la surface (1, 2) du substrat,

b) dépôt, sur toute la surface, d'une première couche de polysilicium (4) non dopée, avec une épaisseur de couche, d'environ 300 nm, et implantation de la première couche de polysilicium (4) avec des ions de bore (5) jusqu'à une profondeur correspondant au maximum à la moitié de l'épaisseur de la couche (4),

c) dépôt d'une seconde couche d'oxyde de silicium (6) sur toute la surface,

d) mise en oeuvre d'une technique (7) utilisant une laque photosensible pour définir la région de base (13, 14) et la région d'émetteur (12) située sur la région de base (13, 14),

e) mise en oeuvre d'un procédé de corrosion ionique réactive anisotrope pour éliminer la seconde couche d'oxyde de silicium (6) non recouverte par le masque de laque photosensible (7),

f) mise en oeuvre d'un procédé de corrosion ionique réactive anisotrope pour éliminer la première couche de polysilicium (4, 5) non recouverte par la seconde couche d'oxyde de silicium (6), à un degré tel qu'au maximum environ 100 nm de la première couche de polysilicium (4) subsistent sur la surface (1, 2) du substrat,

g) production d'une troisième couche d'oxyde de silicium (8) pour fabriquer l'isolation des flancs (voir flèche 9) par oxydation superficielle de la couche résiduelle de silicium,

h) dépôt d'une quatrième couche d'oxyde de silicium (10) en vue d'élargir l'isolation (9) des flancs,

i) mise en oeuvre d'un procédé de corrosion ionique réactive anisotrope sans masque pour l'élimination de la quatrième couche d'oxyde de silicium (10), à l'exception de l'isolation (9) des flancs et pour l'élimination de la troisième couche d'oxyde de silicium (8) dans la région d'émetteur (12), avec le rapport de la vitesse de corrosion verticale à la vitesse de corrosion latérale > 5: 1 et le rapport de la vitesse de corrosion de l'oxyde à la vitesse de corrosion du silicium > 15 :1,

j) dépôt et structuration d'une seconde couche de polysilicium (11), dopée par de l'arsenic ou de l'antimoine, dans la région d'émetteur (12),

k) mise en œuvre d'un traitement thermique permettant d'activer la région d'émetteur (12) et les régions de base (13, 14) et

l) ouverture des contacts en direction des régions de polysilicium (4, 5, 11) et de la borne (13) de raccordement de la base et de la borne (11) de raccordement de l'émetteur.

2. Procédé suivant la revendication 1, caractérisé par le fait qu'on utilise un substrat en silicium dopé du type n et comportant une couche épitaxiale (2) dopée du type n⁻.

3. Procédé suivant la revendication 1 et/ou 2, caractérisé par le fait qu'à la place de l'étape opératoire (a), on utilise la technique d'isolation en sillon ou une oxydation locale (technique LOCOS).

4. Procédé suivant les revendications 1 à 3, caractérisé par le fait qu'on règle l'épaisseur de la seconde couche d'oxyde (6) pour l'étape opératoire (c) à une valeur de l'ordre de 400 nm, l'épaisseur de la troisième couche d'oxyde (8) pour l'étape opératoire (g) à une valeur de l'ordre de 150 nm et l'épaisseur de la quatrième couche d'oxyde (10) pour l'étape opératoire (h) à une valeur de l'ordre de 250 nm.

5. Procédé suivant les revendications 1 à 4, caractérisé par le fait que l'épaisseur de la première couche de polysilicium (4) et de la seconde couche de polysilicium (11) est réglée à une valeur de l'ordre de 300 nm.

6. Procédé suivant les revendications 1 à 5, caractérisé par le fait que dans le cas de l'implantation (5) d'ions de bore lors de l'étape opératoire (b), on règle une dose de $5 \times 10^{15}$ cm⁻² et une énergie de 40 keV.

7. Procédé suivant les revendications 1 à 6, caractérisé par le fait que le procédé de corrosion ionique réactive mis en œuvre lors des étapes opératoires e) et i) est exécuté avec un mélange de trifluorométhane ($CHF_3$) et 5 à 8 % d'oxygène et que le procédé de corrosion ionique réactive exécuté lors de l'étape opératoire f) est exécuté avec un mélange de trichlorure de bore ($BCl_3$), de chlore et d'hélium.

8. Procédé suivant les revendications 1 à 7, caractérisé par le fait qu'on exécute le traitement thermique mis en oeuvre lors de l'étape opératoire l) pendant une durée de 30 minutes entre 950 et l000°C.

9. Procédé suivant les revendications 1 à 8, caractérisé par le fait que la réalisation de la couche d'oxyde de silicium (8) mise en oeuvre lors de l'étape opératoire (g) s'effectue sous une pression normale à 800°C, pendant 5 heures.

10. Procédé suivant les revendications 1 à 8, caractérisé par le fait que la production de la couche d'oxyde de silicium (8) mise en œuvre lors de l'étape opératoire (g) s'effectue sous une pression élevée de l'ordre de 20 bars à 800°C pendant 20 minutes.

0 142 632

FIG 1

FIG 2

FIG 3

1

FIG 4

FIG 5

FIG 6